# EUROPEAN PATENT SPECIFICATION

(11) **EP 2 079 099 B1**
(45) Date of publication and mention of the grant of the patent: **16.09.2015**
(21) Application number: 08150201.5
(22) Date of filing: 11.01.2008
(51) Int. Cl.: H01L 21/67, H01L 21/02

(54) **Method and apparatus for preventing galvanic corrosion in semiconductor processing**
Verfahren und Vorrichtung zur Verhinderung galvanischer Korrosion bei der Halbleiterverarbeitung
Procédé et appareil pour la prévention de la corrosion galvanique dans le traitement de semi-conducteurs

(43) Date of publication of application: 15.07.2009
(73) Proprietor: IMEC, 3001 Leuven (BE); Katholieke Universiteit Leuven, K.U. Leuven R&D, 3000 Leuven (BE)
(72) Inventor: Garaud, Sylvain, B-3001, HEVERLEE (BE); Vos, Rita, B-3128, TREMELO (BE); Leunissen, Leonardus, B-1320, HAMME-MILLE (BE); Mertens, Paul, B-2820, BONHEIDEN (BE)
(74) Representative: Pronovem

(56) References cited:
- WO-A-02/057179
- WO-A-2006/022452
- US-A1- 2002 166 570
- US-A1- 2004 222 100
- US-A1- 2005 155 869

## Description

### Field of the Invention

The invention as claimed in claim 1 is related to semiconductor processing, in particular to wet cleaning processes. The invention is concerned with the prevention of galvanic corrosion of (semi)conductor structures during such process steps.

### State of the art.

### Prior art

US2005/0155869: electropolishing method for removing particulate contamination from a wafer whereby the wafer is configured opposite a counterelectrode in an electrolyte and an electrical bias is applied across the resulting cell. Additionally, the wafer is rotated with respect to the counterelectrode.

WO2006/022452: a polishing method and apparatus comprising continuously supplying I electrolyte to the surface of a positively biased wafer which is in rotational motion with respect to to the cathode.

US2004/0222100: method of electrochemical processing whereby the electrolyte is degassed before use.

In integrated circuit process technology, a silicon wafer is subjected to a series of process steps referred to as Front End Of Line processing (FEOL), which refers to the steps taking place up to and not including the first metallisation steps. During FEOL, metal/polysilicon gate structures are produced on the wafer by known production techniques. With CMOS devices scaling beyond the 65nm node, short channel effects become dominant, leading to high leakage currents. Non-planar device architectures such as Multiple Gate Field Effect Transistor (MUGFET) and in particular the double gated MUGFET structure known as FinFET are considered to overcome this effect. However, these structures represent a challenge in terms of gate patterning and processing. In the case of metal gate FinFET structures, in order to avoid severe recess of the buried field oxide, etching of the gate stack is performed in two steps, wherein a metal layer acts as etch stop layer during the first step. As a result, the wafer surface comprises polySi-stacks, surrounded by and in electrical contact with a metal layer covering the whole of the wafer surface. At this stage, the wafer needs to undergo a cleaning treatment, in order to remove residues from the preceding etch steps. Such cleaning typically takes place in an aqueous HF (Hydrofluoric acid) solution, which is an electrolytic solution. This combination however leads to corrosion of the polySi-structures, due to the phenomenon of galvanic corrosion. Because of the difference in electrochemical potential of the polysilicon and the surrounding metal, a galvanic cell is generated between these two materials, leading to a spontaneous oxidation-reduction reaction. While the metal acts a cathode, the polysilicon will act as the anode, and will thus be subjected to a forced and unwanted oxidation (i.e. corrosion), during the HF treatment. Specifically, the PolySi structures are underetched by the corrosion.

The same problem may occur during other processes where during a stage of the process, semiconductor or other structures comprising a first conductive material are produced on a wafer surface, and are surrounded by and in contact with a layer of a second conductive material, such as a metal layer, said contact taking place between said first and second material.

### Aims of the invention

The invention aims to provide a method as claimed in claim 1 and apparatus as claimed in claims 7, 10 for cleaning a semiconductor substrate comprising structures surrounded by and in electrical contact with a conducting or semiconducting layer covering substantially the whole of the substrate surface, wherein corrosion of said structures is prevented.

### Summary

The invention is related to methods and apparatuses as described in the appended claims.

Described herein is a method for cleaning a semiconductor substrate comprising on a surface of the substrate at least one structure comprising a first conducting or semiconducting material, surrounded by a layer of a second conducting or semiconducting material, said layer essentially extending over the totality of said surface, said first and second material being in physical contact, the method comprising the steps of:
- providing said substrate,
- positioning a counterelectrode facing said substrate surface,
- supplying an electrolytic fluid to the space between said surface and the electrode, said counterelectrode acting as an anode in the galvanic cell defined by the substrate surface, the cleaning fluid and the counterelectrode.

Further described herein is an apparatus for cleaning a semiconductor substrate, while protecting a surface of the substrate by a cathodic protection mechanism, said apparatus comprising :
- a holder for holding a substrate, said holder comprising a means for clamping said substrate (1,13),
- at least one counterelectrode, arranged to be placed facing said substrate surface,
- a means for supplying a cleaning fluid to the space between said counterelectrode and said surface.

### Brief description of the figures

Figures 1a-1e illustrate a typical field of application.

Figure 2 illustrates the method, applied to a wafer as shown in figure 1d.

Figure 3 illustrates the design of an apparatus.

Figure 4 illustrates another apparatus.

Figure 5 illustrates multiple counterelectrodes.

### Detailed description

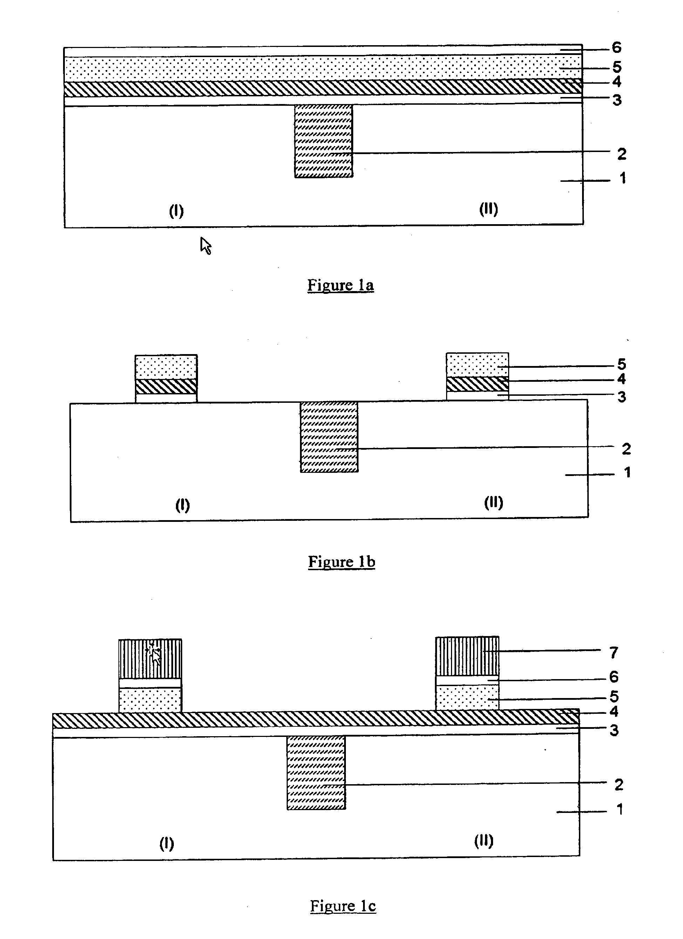

Figure 1a-1e illustrates one of the main fields of application, which concerns the FEOL processing steps during processing of CMOS (complementary metal-oxide-semiconductor) devices. Active areas (I, II) and shallow trench isolation (STI) areas 2 are defined on a substrate 1. A gate stack is formed by depositing a gate dielectric 3, a gate electrode 4, 5 and a hard mask layer 6 over the whole substrate (fig. 1a). The gate dielectric 3 comprises at least one layer of dielectric material. The gate electrode has conductive properties and comprises at least one layer of metal 4 and a layer of polysilicon (poly-Si) or amorphous silicon (a-Si) 5, overlying the metal layer. The hardmask layer 6 overlying the polySi/a-Si layer can be a Si-based dielectric, such as silicon oxide, silicon nitride or silicon carbide.

In standard CMOS processing, a single etch step is performed to produce the gate stacks as shown in figure 1b. In the case of FinFETs, the wet removal of the hardmask layer 6 causes severe recess of the buried field oxide. Therefore the etch sequence of the gate stack is modified and the gate is patterned in 2 steps. In a first step the hardmask 6 and the polySi 5 is patterned using a photoresist mask 7, stopping on the metal layer 4 as shown in figure 1c for simplicity on planar device architecture. Multi-step etching may be necessary in other cases as well, even when the field oxide protection is not the main consideration. Gate electrodes comprising multiple layers (poly and one or more metal layers for example) may require etching in two or more steps, the number of steps being in relation to the number of layers present.

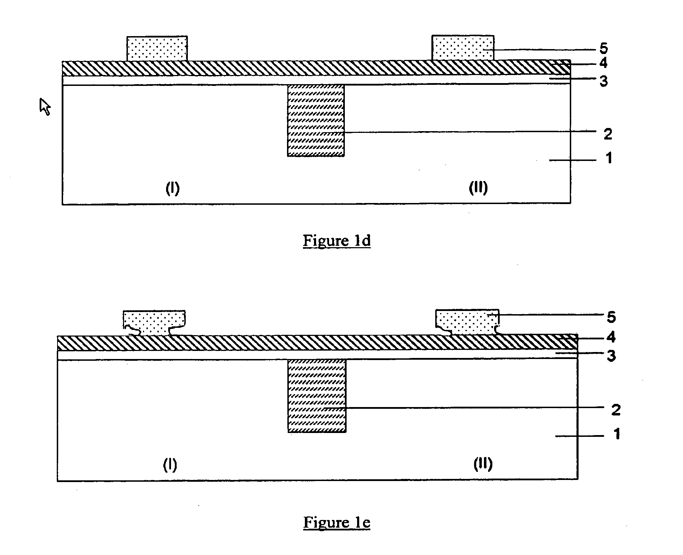

After the first etch step, the photoresist 7 and the hardmask layer 6 are removed (fig. 1d). Wet cleaning solutions, most preferably HF-based solutions are used to remove the photoresist residues and the hardmask 6. When the metal layer 4 comprises a noble metal and the cleaning solution used to remove the resist residues and the hardmask 6 is a HF-based mixture, an under-etching (attack) of the polysilicon layer 5 occurs, because of the galvanic corrosion effect, as shown in Figure 1e.

In a second etch step (not shown), the metal layer 4 and the gate dielectric 3 are etched, using the polySi/a-Si layer 5 as mask layer. After gate patterning a conventional FEOL process flow comprises junction formation (implantation and thermal annealing), dielectric spacers definition and silicidation.

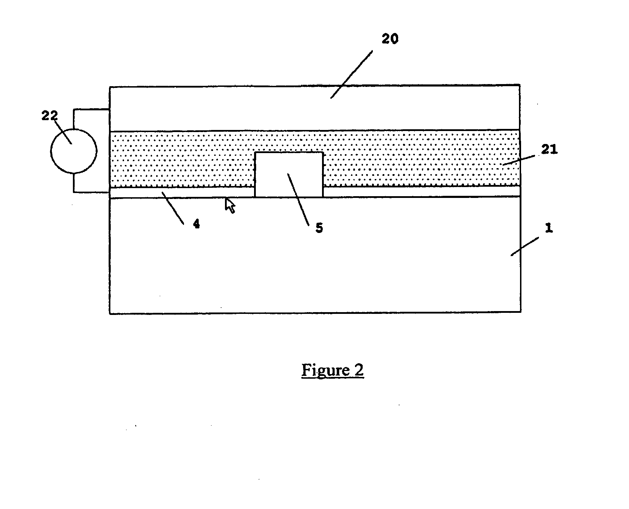

Figure 1d therefore shows an example of a substrate which is treatable by the method or in the apparatus. It concerns a semiconductor substrate 1, preferably Si, comprising at least one elevated semiconductor structure 5 on its surface, preferably a polySi stack or a plurality of polySi stacks. Said at least one structure is surrounded by a metal layer 4, extending substantially over the entire surface of the substrate and being in electrical contact with the structures 5. This type of substrate is typically an intermediate product during FEOL CMOS processing. Other applications are however possible. The term 'surrounding' means that the semiconductor structures may be present on top of a continuous metal layer (case shown in fig. 1d), or that the metal layer is adjacent to the structures (illustrated e.g. by figure 2). In both cases, the metal layer and the structures are in electrical contact.

Generally, the structures 5 are structures comprising a first conducting or semiconducting material, e.g. comprising a layer of such a material, and said structures 5 are surrounded (as defined above) by a layer of a second conducting or semiconducting material (preferably metal), wherein the first and second material are in physical contact and have a mutually different electrochemical potential. The structures 5 may comprise multiple layers of metal and/or semiconductor material. Substrate 1 can comprise any semiconducting material including, but not limited to: Si, Ge, SiGe, GaAs, InAs, InP and other III/V semiconductor compounds. Semiconductor substrate 1 can also be a layered substrate comprising the same or different semiconducting material, e.g., Si/Si or Si/SiGe, as well as a silicon-on-insulator (SOI) substrate.

According to an example, illustrated by figure 2, the method comprises the steps of :
- Providing a substrate as described above, i.e. provided with said structure(s) 5 on its surface, surrounded by a layer of conducting or semiconducting material, preferably metal. For the sake of conciseness, the following description refers to semiconductor structures and a metal layer, but these terms can be replaced by 'structures comprising first conducting or semiconducting material' and `layer of second conducting or semiconducting material', respectively, throughout the description.
- Positioning a counterelectrode 20 facing said surface,
- Supplying an electrolytic cleaning fluid 21 to the space between the substrate surface and the electrode,
- Using and/or actively applying a voltage difference between the metal layer present on the substrate surface, and the counterelectrode. The voltage difference may be due to a difference in electrochemical potential between the metal layer 4 and the counter electrode 20, or it may be obtained or further enhanced by a power source 22 connected between the counterelectrode and the metal layer.
- The preceding steps are preferably followed by standard rinsing and/or drying steps to produce a clean substrate. During rinsing and/or drying steps the counterelectrode is not require :it can be removed from the cleaning chamber or the distance between the counterelectrode and the substrate can be increased.

The abovementioned electrochemical potential difference and/or the polarity of the voltage applied by the external power source are such that the counterelectrode works as an anode in the galvanic cell defined by the substrate surface comprising metal layer and semiconductor structures, the fluid and the counterelectrode. The entire metal covered surface of the substrate then works as a cathode. In this way, cathodic protection of the metal layer 4 and of the semiconductor structures 5 is obtained. When an external voltage is applied, impressed current cathodic protection (ICCP) takes place.

The counterelectrode is 'facing' the substrate surface, in other words : the counterelectrode has a surface which is put at a given distance from the substrate surface so that the counterelectrode surface covers at least a portion of the substrate surface. The distance is preferably relatively short (order of mm). The counterelectrode is not present in a separate container. According to one example, the counterelectrode is flat, preferably circular-shaped, and positioned essentially parallel to the substrate surface which can be the surface of a circular semiconductor wafer. As explained later, the counterelectrode can equally have a concave-like surface. Another example is related to multiple electrodes arranged at various distances over the surface.

The electrolytic cleaning fluid can be a liquid or a mixture of a liquid and a gas. For example in the case of FEOL CMOS processing, an aqueous HF solution may be used. This solution can be mixed with nitrogen gas. The cleaning fluid comprises substantially no metal ions.

In the method, a cleaning fluid is supplied to the space between the substrate and the counterelectrode. According to an example, this supply involves a continuous movement of cleaning fluid over the surface of the substrate. This can be obtained by supplying fluid in one or more locations, e.g. through nozzles, and draining the fluid at other locations, e.g. at the edges of the substrate. During the cleaning step, the substrate is preferably rotated. The rotation speed may be up to 2000rpm.

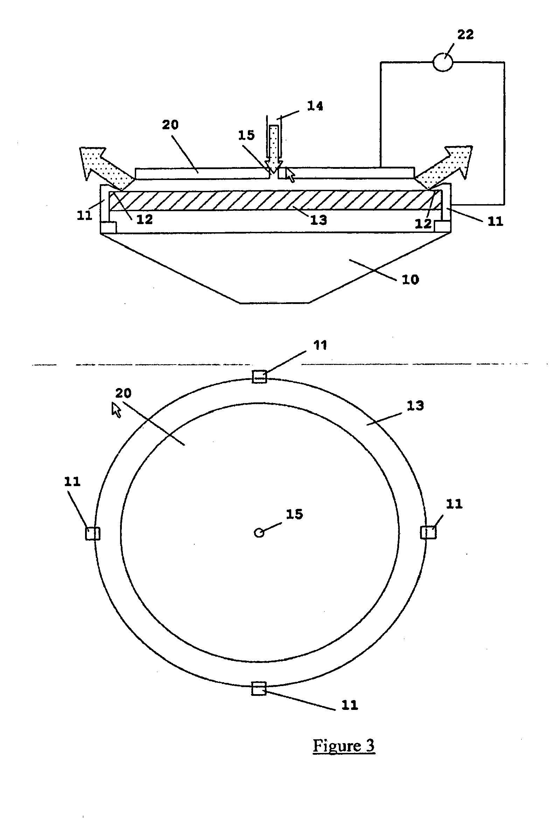

Figure 3 is a schematic view of an apparatus. The apparatus comprises a support portion 10, provided with a number of clamping and contact pins 11. Four pins are shown in the drawing but more are possible. The pins are provided with a contact surface 12 that contacts the upper surface of a wafer/substrate 13. While being contacted thus, the wafer is clamped between the pins in an adequate manner. Above the wafer surface, the counterelectrode 20 is present. The counterelectrode in this example is circular and essentially concentrically positioned with respect to the equally circular wafer. Other shapes of the substrate and electrode are possible. A power source 22 is connected between the pins 11 and the counter electrode 20. A means for supplying a cleaning fluid is provided, for example a nozzle 14. In figure 3, a central opening 15 is provided in the counterelectrode 20, and the nozzle 14 is arranged to supply fluid centrally through said central opening 15. Said cleaning fluid is thus induced to flow outward from the central opening towards the edges of the wafer, where it is drained in an appropriate way, as indicated by the arrows in figure 3. Other ways of supplying the fluid to the space between the wafer and the counterelectrode can be imagined by the skilled person.

The support portion 10 may be rotatable, in which case adequate measures need to be taken to ensure the contact between the rotating pins 11 and the power source 22. The pins and the wafer are rotating together as one piece. The rotation speed may be up to 2000 RPM.

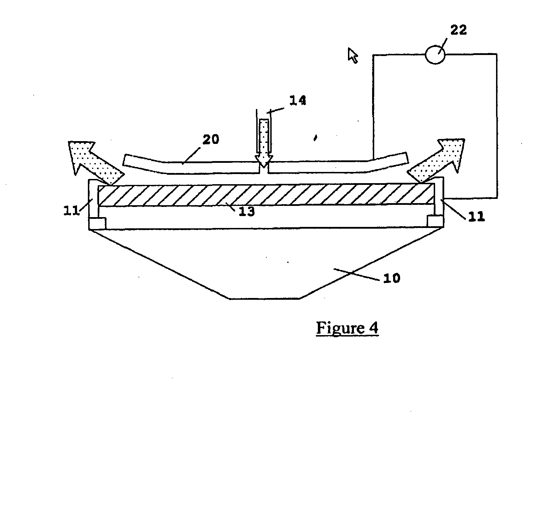

According to another example, the counterelectrode 20 has a specially designed and optimized cross section towards the wafer surface (for instance a concave-like shape), as shown in figure 4. This example is apt to diminish an overprotection taking place at the wafer's edges. With a flat counterelectrode, the protection can be non-uniform over the wafer because of the non-uniform resistivity of the metal layer. The potential drop at the wafer surface from the edge to the centre can be decreased by an optimized counter electrode shape, such as the shape shown in figure 4. The distance between the wafer and the counterelectrode is substantially constant on a central portion of the wafer, and is diverging on an external portion of the wafer. Other shapes of the electrode are possible, as can be appreciated by the skilled person.

The size and number of counterelectrodes can also differ from the example shown in figure 4. A single electrode of smaller size can be positioned to protect only a portion of the wafer surface.

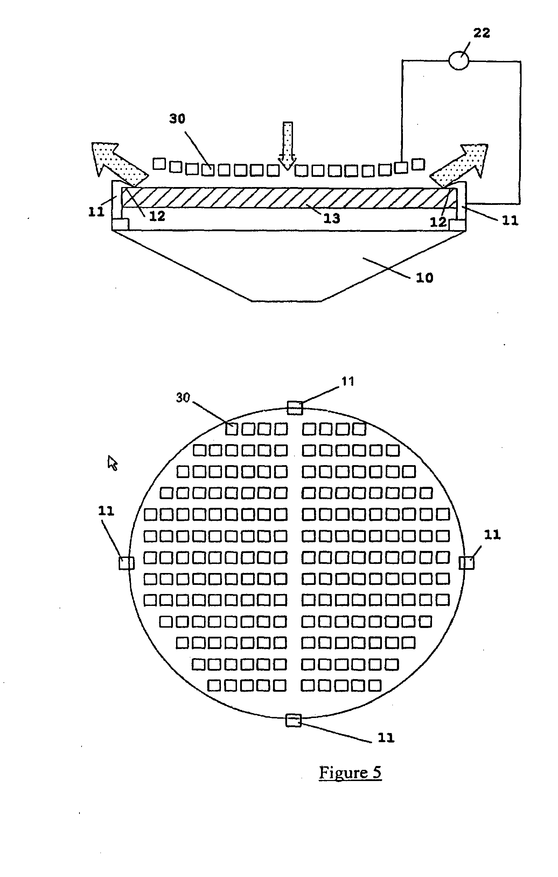

Figure 5 shows another possible example, comprising a set of different counterelectrodes 30, arranged in a grid, each electrode facing the wafer surface, each electrode being connected to the wafer surface via the power source 22. In this example, means are advantageously provided to adjust the vertical position of the individual electrodes with respect to the wafer surface, in order to position electrodes at the optimum distance from the wafer surface. For example, electrodes placed on the outer circumference of the wafer surface may be positioned at a larger distance from the wafer than electrodes placed in the centre (as illustrated in figure 5). This example also allows to minimise the influence of the hydrodynamics of the cleaning fluid, which might be more likely to interfere with the cleaning performance when one massive counterelectrode is used. The arrangement with multiple counterelectrodes arranged in a grid allows the possibility to use a scanning nozzle that can provide the cleaning fluid through the openings of the grid.

According to another example, the wafer and the counterelectrode are submerged together in a bath of the cleaning fluid.

The counterelectrode 20 is preferably essentially inert to the cleaning fluid, so that substantially no contamination of the substrate is generated. In the case of HF, the counterelectrode can be a platinum electrode or a platinum- covered electrode (e.g. a semiconductor material/wafer covered with a layer of platinum). Applied current densities may be between 100mA/m2 and 1A/m2.

There are applications for logic and for memory circuits. For logic, this is the metal gate/poly coupling in HF as described above or double metal gate stacks applications. For memory, the gate stack may have an additional layer (for instance W) to increase the conductivity.

The field of application is related to the processing of any conductive stack by sequence of dry etching and cleaning (under cathodic protection), avoiding the corrosion (in particular galvanic enhanced corrosion) during the cleaning, leading to a well defined gate profile.

## Claims

1. A method for cleaning a semiconductor substrate (1,13) comprising on a surface of the substrate:
• at least one structure (5), said structure comprising a first conducting or semiconducting material,
• a layer (4) of a second conducting or semiconducting material, said first and second material being in physical contact, and having a mutually different electrochemical potential, said layer extending over the totality of said surface, said at least one structure being present on top of said layer (4), or said layer (4) being adjacent to said at least one structure,
the method comprising the steps of:
- providing said substrate (1),
- positioning a counterelectrode (20,30) facing said substrate surface,
- supplying an electrolytic fluid (21) to the space between said surface and the electrode, said counterelectrode acting as an anode in the galvanic cell defined by the substrate surface, the cleaning fluid (21) and the counterelectrode (20,30),
and wherein the operation as anode is achieved through the electrochemical potential difference between the counterelectrode (20,30) and the layer (4) of the second conducting or semiconducting material, and wherein the method further comprises the step of applying a voltage difference between the layer (4) of a second conducting or semiconducting material and the counterelectrode, said voltage difference being applied so that the counterelectrode operates as an anode.

2. The method according to claim 1, wherein
the counterelectrode (20,30) is inert with respect to the cleaning fluid.

3. The method according to claim 1 or 2, wherein said structures (5) are semiconductor structures and wherein said layer (4) of a second conducting or semiconducting material is a metal layer.

4. The method according to any one of claims 1 to 3, wherein said fluid (21) is supplied in one or more locations on the substrate surface covered by said electrode(s), and drained on another location on said surface, so that during the cleaning operation, a continuous stream of cleaning fluid is supplied over the surface to be cleaned.

5. The method according to claim 4, wherein the substrate is a circular wafer (13) and the counterelectrode (20) is equally circular and arranged concentrically with respect to the wafer, and wherein the counterelectrode is provided with a hole (15) in the centre, the supply of fluid being provided through said hole, so that cleaning fluid flows outward from the centre of the wafer surface to the edges, during the cleaning operation.

6. The method according to any one of the preceding claims, wherein said substrate (1, 13) rotates during the cleaning operation.

7. An apparatus for cleaning a semiconductor substrate, while protecting a surface of the substrate by a cathodic protection mechanism, said apparatus comprising :
- a holder (10) for holding a substrate (1,13), said holder comprising a means (11) for clamping said substrate (1,13),
- at least one counterelectrode (20,30), arranged to be placed facing said substrate surface,
- a means for supplying a cleaning fluid (21) to the space between said counterelectrode (20,30) and said surface
wherein the counterelectrode (20) has a concave-like shape, the distance between the counterelectrode and the surface to be cleaned being smaller in the centre of said surface than on the outer edge of said surface, in order to obtain a uniform protection over the surface to be cleaned; and
wherein said clamping means are in the form of a number of clamping pins (11) arranged to clamp the substrate and to contact the surface to be cleaned, the apparatus further comprising a voltage source (22) arranged to apply a voltage difference between said clamping pins and said counterelectrode.

8. The apparatus according to claim 7, wherein the means for supplying a cleaning fluid comprise one or more nozzles (14) arranged to supply fluid to the space between the counterelectrode and the surface to be cleaned.

9. The apparatus according to claim 8, wherein the holder (10) is arranged for clamping a substantially circular substrate (13), and wherein a single counterelectrode (20) is arranged to be placed facing the substrate, and wherein said counterelectrode comprises a central hole (15), a nozzle (14) being arranged to supply the cleaning fluid through said hole, to the space between the counterelectrode and the surface to be cleaned.

10. An apparatus for cleaning a semiconductor substrate, while protecting a surface of the substrate by a cathodic protection mechanism, said apparatus comprising :
- a holder (10) for holding a substrate (1,13), said holder comprising a means (11) for clamping said substrate (1,13),
- at least one counterelectrode (20,30), arranged to be placed facing said substrate surface,
- a means for supplying a cleaning fluid (21) to the space between said counterelectrode (20,30) and said surface,
wherein a plurality of counterelectrodes (30) are provided, arranged to be positioned facing the surface to be cleaned, and wherein means are provided to adjust the distance between the counterelectrodes and the surface to be cleaned, independently for each electrode; and wherein said clamping means are in the form of a number of clamping pins (11) arranged to clamp the substrate and to contact the surface to be cleaned, the apparatus further comprising a voltage source (22) arranged to apply a voltage difference between said clamping pins and said plurality of counterelectrodes (30).

11. The apparatus according to claim 10, wherein said electrode (20,30) is a platinum or platinum-covered electrode.

## Patentansprüche

1. Verfahren zum Reinigen eines Halbleitersubstrats (1,13), das auf einer Oberfläche des Substrats Folgendes umfasst:
• mindestens eine Struktur (5), wobei die Struktur ein erstes leitendes oder halbleitendes Material umfasst,
• eine Schicht (4) aus einem zweiten leitenden oder halbleitenden Material, wobei das erste und das zweite Material in physischem Kontakt miteinander stehen, und ein gegenseitig unterschiedliches elektrochemisches Potential aufweisen, wobei sich die Schicht über die Gesamtheit der Oberfläche erstreckt, wobei die mindestens eine Struktur auf der Oberseite der Schicht (4) vorhanden ist, oder wobei die Schicht (4) der mindestens einen Struktur benachbart ist, wobei das Verfahren die folgenden Schritte umfasst:
- Bereitstellen des Substrats (1),
- Anordnen einer Gegenelektrode (20,30), die der Substratoberfläche gegenüber liegt,
- Zuführen eines Elektrolytfluids (21) in den Raum zwischen der Oberfläche und der Elektrode, wobei die Gegenelektrode als eine Anode in der galvanischen Zelle, die durch die Substratoberfläche, das Reinigungsfluids (21) und die Gegenelektrode (20,30) definiert ist, dient,
und wobei der Betrieb als Anode durch die erzielte elektrochemische Potentialdifferenz zwischen der Gegenelektrode (20,30) und der Schicht (4) des zweiten leitenden oder halbleitenden Materials erzielt wird, und wobei das Verfahren weiter den Schritt des Anlegens einer Spannungsdifferenz zwischen der Schicht (4) aus einem zweiten leitenden oder halbleitenden Material und der Gegenelektrode umfasst, wobei die Spannungsdifferenz derart angelegt wird, dass die Gegenelektrode als eine Anode dient.

2. Verfahren nach Anspruch 1, wobei die Gegenelektrode (20,30) inert mit Bezug auf das Reinigungsfluid ist.

3. Verfahren nach Anspruch 1 oder 2, wobei die Strukturen (5) Halbleiterstrukturen sind und wobei die Schicht (4) aus einem zweiten leitenden oder halbleitenden Material eine Metallschicht ist.

4. Verfahren nach einem der Ansprüche 1 bis 3, wobei das Fluid (21) an einer oder an mehreren Stellen auf der Substratoberfläche, die durch die Elektrode(n) bedeckt ist, zugeführt wird, und an einer anderen Stelle auf der Oberfläche abgelassen wird, so dass während des Reinigungsvorgangs ein kontinuierlicher Strom von Reinigungsfluid über die Oberfläche, die gereinigt werden soll, zugeführt wird.

5. Verfahren nach Anspruch 4, wobei das Substrat ein runder Wafer (13) ist und die Gegenelektrode (20) ebenfalls rund und konzentrisch mit Bezug auf den Wafer angeordnet ist, und wobei die Gegenelektrode mit einem Loch (15) in der Mitte ausgestattet ist, wobei das Fluid, das bereitgestellt wird, durch das Loch zugeführt wird, so dass das Reinigungsfluid während des Reinigungsvorgangs von der Mitte der Waferoberfläche an die Kanten nach außen fließt.

6. Verfahren nach einem der vorhergehenden Ansprüche, wobei das Substrat (1,13) sich während des Reinigungsvorgangs dreht.

7. Gerät zum Reinigen eines Halbleitersubstrats, während eine Oberfläche des Substrats durch einen kathodischen Schutzmechanismus geschützt wird, wobei das Gerät Folgendes umfasst:
- einen Halter (10) zum Halten eines Substrats (1,13), wobei der Halter ein Mittel (11) zum Klemmen des Substrats (1,13) umfasst,
- mindestens eine Gegenelektrode (20,30), die angeordnet ist, um sich gegenüber der Substratoberfläche zu befinden,
- ein Mittel zum Zuführen eines Reinigungsfluids (21) in den Raum zwischen der Gegenelektrode (20,30) und der Oberfläche wobei die Gegenelektrode (20) eine konkavartige Form aufweist, wobei der Abstand zwischen der Gegenelektrode und der Oberfläche, die gereinigt werden soll, in der Mitte der Oberfläche kleiner als auf der äußeren Kante der Oberflache ist, um einen einheitlichen Schutz über der Oberfläche, die gereinigt werden soll, zu erhalten; und
wobei die Klemmmittel die Form einer Anzahl von Klemmbolzen (11) aufweisen, die angeordnet sind, um das Substrat zu klemmen und mit der Oberfläche, die gereinigt werden soll, in Kontakt zu kommen, wobei das Gerät weiter eine Spannungsquelle (22) umfasst, die angeordnet ist, um eine Spannungsdifferenz zwischen den Klemmbolzen und der Gegenelektrode anzulegen.

8. Gerät nach Anspruch 7, wobei das Mittel zum Zuführen einer Reinigungsflüssigkeit eine oder mehrere Düsen (14) umfasst, die angeordnet sind, um Fluid in den Raum zwischen der Gegenelektrode und der Oberfläche, die gereinigt werden soll, zuzuführen.

9. Gerät nach Anspruch 8, wobei der Halter (10) angeordnet ist, um ein im Wesentlichen rundes Substrat (13) zu klemmen, und wobei eine einzige Gegenelektrode (20) angeordnet ist, um sich gegenüber dem Substrat zu befinden, und wobei die Gegenelektrode ein mittleres Loch (15) umfasst, wobei eine Düse (14) angeordnet ist, um das Reinigungsfluid durch das Loch in den Raum zwischen der Gegenelektrode und Oberfläche, die gereinigt werden soll, zuzuführen.

10. Gerät zum Reinigen eines Halbleitersubstrats, während eine Oberfläche des Substrats durch einen kathodischen Schutzmechanismus geschützt wird, wobei das Gerät Folgendes umfasst:
- einen Halter (10) zum Halten eines Substrats (1,13), wobei der Halter ein Mittel (11) zum Klemmen des Substrats (1,13) umfasst,
- mindestens eine Gegenelektrode (20,30), die angeordnet ist, um sich gegenüber der Substratoberfläche zu befinden,
- ein Mittel, um ein Reinigungsfluid (21) in den Raum zwischen der Gegenelektrode (20,30) und der Oberfläche zuzuführen, wobei eine Vielzahl von Gegenelektroden (30) vorgesehen ist, die angeordnet ist, um gegenüber der Oberfläche, die gereinigt werden soll, positioniert zu sein, und wobei Mittel bereitgestellt sind, um den Abstand zwischen den Gegenelektroden und der Oberfläche, die gereinigt werden soll, unabhängig für jede Elektrode einzustellen; und wobei die Klemmmittel die Form einer Anzahl von Klemmbolzen (11) aufweisen, die angeordnet ist, um das Substrat zu klemmen und mit der Oberfläche, die gereinigt werden soll, in Kontakt zu kommen, wobei das Gerät weiter eine Spannungsquelle (22) umfasst, die angeordnet ist, um eine Spannungsdifferenz zwischen den Klemmbolzen und der Vielzahl von Gegenelektroden (30) anzulegen.

11. Gerät nach Anspruch 10, wobei die Elektrode (20,30) eine Platin- oder Platin-bedeckte Elektrode ist.

## Revendications

1. Procédé de nettoyage d'un substrat semi-conducteur (1, 13) comprenant sur une surface du substrat :
. au moins une structure (5), ladite structure comprenant un premier matériau conducteur ou semi-conducteur,
. une couche (4) d'un deuxième matériau conducteur ou semi-conducteur, lesdits premier et deuxième matériaux étant en contact physique, et ayant des potentiels électrochimiques mutuellement différents, ladite couche s'étendant sur la totalité de ladite surface, ladite au moins une structure étant présente sur le dessus de ladite couche (4), ou ladite couche (4) étant adjacente à ladite au moins une structure,
le procédé comprenant les étapes :
- de fourniture dudit substrat (1),
- de positionnement d'une contre-électrode (20, 30) face à ladite surface du substrat,
- de fourniture d'un fluide électrolytique (21) dans l'espace entre ladite surface et l'électrode, ladite contre-électrode agissant en tant qu'anode dans la cellule galvanique définie par la surface du substrat, le fluide de nettoyage (21) et la contre-électrode (20, 30),
et dans lequel le fonctionnement en tant qu'anode est réalisé par l'intermédiaire de la différence de potentiel électrochimique entre la contre-électrode (20, 30) et la couche (4) du deuxième matériau conducteur ou semi-conducteur, et dans lequel le procédé comprend en outre l'étape d'application d'une différence de tension entre la couche (4) d'un deuxième matériau conducteur ou semi-conducteur et la contre-électrode, ladite différence de tension étant appliquée de sorte que la contre-électrode fonctionne en tant qu'anode.

2. Procédé selon la revendication 1, dans lequel la contre-électrode (20, 30) est inerte par rapport au fluide de nettoyage.

3. Procédé selon la revendication 1 ou 2, dans lequel lesdites structures (5) sont des structures semi-conductrices, et dans lequel ladite couche (4) d'un deuxième matériau conducteur ou semi-conducteur est une couche métallique.

4. Procédé selon l'une quelconque des revendications 1 à 3, dans lequel ledit fluide (21) est délivré à un ou plusieurs emplacements sur la surface de substrat couverte par ladite électrode ou lesdites électrodes, et évacué sur un autre emplacement sur ladite surface, de sorte que, pendant l'opération de nettoyage, un écoulement continu du fluide de nettoyage est délivré sur la surface à nettoyer.

5. Procédé selon la revendication 4, dans lequel le substrat est une tranche semi-conductrice (13) circulaire et la contre-électrode (20) est également circulaire et agencée de manière concentrique par rapport à la tranche semi-conductrice, et dans lequel la contre-électrode est pourvue d'un trou (15) au centre, la fourniture de fluide étant réalisée à travers ledit trou, de sorte que le fluide de nettoyage s'écoule à l'extérieur du centre de la surface de la tranche semi-conductrice vers les bords, pendant l'opération de nettoyage.

6. Procédé selon l'une quelconque des revendications précédentes, dans lequel ledit substrat (1, 13) tourne pendant l'opération de nettoyage.

7. Appareil pour nettoyer un substrat semi-conducteur, tout en protégeant une surface du substrat par un mécanisme de protection cathodique, ledit appareil comprenant :
- un support (10) pour supporter un substrat (1, 13), ledit support comprenant des moyens (11) pour serrer ledit substrat (1, 13),
- au moins une contre-électrode (20, 30), agencée pour être placée face à ladite surface du substrat,
- des moyens pour fournir un fluide de nettoyage (21) dans l'espace entre ladite contre-électrode (20, 30) et ladite surface,
dans lequel la contre-électrode (20) a une forme sensiblement concave, la distance entre la contre-électrode et la surface à nettoyer étant plus petite au centre de ladite surface que sur le bord extérieur de ladite surface, afin d'obtenir une protection uniforme sur la surface à nettoyer ; et
dans lequel lesdits moyens de serrage sont sous la forme d'un certain nombre de broches de serrage (11) agencées pour serrer le substrat et pour venir en contact avec la surface à nettoyer, l'appareil comprenant en outre une source de tension (22) agencée pour appliquer une différence de tension entre lesdites broches de serrage et ladite contre-électrode.

8. Appareil selon la revendication 7, dans lequel les moyens pour fournir un fluide de nettoyage comprennent une ou plusieurs buses (14) agencées pour fournir un fluide dans l'espace entre la contre-électrode et la surface à nettoyer.

9. Appareil selon la revendication 8, dans lequel le support (10) est agencé pour serrer un substrat (13) sensiblement circulaire, et dans lequel une contre-électrode (20) unique est agencée pour être placée face au substrat, et dans lequel ladite contre-électrode comprend un trou central (15), une buse (14) étant agencée pour fournir le fluide de nettoyage à travers ledit trou, dans l'espace entre la contre-électrode et la surface à nettoyer.

10. Appareil pour nettoyer un substrat semi-conducteur, tout en protégeant une surface du substrat par un mécanisme de protection cathodique, ledit appareil comprenant :
- un support (10) pour supporter un substrat (1, 13), ledit support comprenant des moyens (11) pour serrer ledit substrat (1, 13),
- au moins une contre-électrode (20, 30), agencée pour être placée face à ladite surface du substrat,
- des moyens pour fournir un fluide de nettoyage (21) dans l'espace entre ladite contre-électrode (20, 30) et ladite surface,
dans lequel une pluralité de contre-électrodes (30) sont prévues, agencées pour être positionnées face à la surface à nettoyer, et dans lequel des moyens sont prévus pour ajuster la distance entre les contre-électrodes et la surface à nettoyer, de manière indépendante pour chaque électrode ;
et dans lequel lesdits moyens de serrage sont sous la forme d'un certain nombre de broches de serrage (11) agencées pour serrer le substrat et pour être en contact avec la surface à nettoyer, l'appareil comprenant en outre une source de tension (22) agencée pour appliquer une différence de tension entre lesdites broches de serrage et ladite pluralité de contre-électrodes (30).

11. Appareil selon la revendication 10, dans lequel ladite électrode (20, 30) est une électrode en platine ou recouverte de platine.
